# EUROPÄISCHE PATENTSCHRIFT

(11) **EP 2 600 145 B1**
(45) Veröffentlichungstag und Bekanntmachung des Hinweises auf die Patenterteilung: **12.08.2015**
(21) Anmeldenummer: 12007745.8
(22) Anmeldetag: 15.11.2012
(51) Int. Cl.: G01N 27/414, H01L 21/56, H01L 23/31, H01L 23/482, H05K 3/40, H01L 23/00

(54) **Integriertes Bauelement mit Leitkleberverbindung**
Integrated component with conductive adhesive bond
Composant intégré avec liaison adhésive conductrice

(30) Priorität: 02.12.2011 DE 102011119957
(43) Veröffentlichungstag der Anmeldung: 05.06.2013
(73) Patentinhaber: Micronas GmbH, 79108 Freiburg (DE)
(72) Erfinder: Wilbertz, Christoph, 79194 Gundelfingen (DE); Kolleth, Tobias, 79108 Freiburg (DE); Frerichs, Heinz-Peter, 79271 St. Peter (DE)
(74) Vertreter: Koch Müller Patentanwaltsgesellschaft mbH

(56) Entgegenhaltungen:
- EP-A2- 2 594 928
- DE-A1- 10 316 933
- DE-A1- 10 343 793
- DE-C1- 19 907 168

## Beschreibung

Die Erfindung betrifft ein integriertes Bauelement mit Leitkleberverbindung Befestigungsvorrichtung gemäß dem Oberbegriff des Patentanspruchs 1.

Aus der DE 10 2005 009 163 A1 ist bekannt, dass auf der passivierten Oberfläche eines Halbleiterkörpers Elektroden mittels Leitklebers zum Anschluss von Bauteilen ausgebildet werden. Des Weiteren ist aus der DE 10 2006 053 461 A1 eine Vorrichtung und Verfahren zum Herstellen einer mikroelektronischen Baugruppe bekannt.

Aus der DE 100 36 178 A1, der DE 42 39 319 C2 und der EP 1 103 808 B1 sind FET-Feuchtesensoren bekannt, bei denen die durch einen Luftspalt von dem Kanalbereich beanstandete Steuerelektrode mittels eines Bondverfahrens mit dem Halbleiterkörper elektrisch verschaltet ist. Die Steuerelektrode wird zusätzlich mittels einer Klemmvorrichtung mit dem Halbleiterkörper kraftschlüssig verbunden.

Des Weiteren sind aus der DE 199 07 168 C1, der US 5 545 589 A, der US 5137 461 A, der DE 103 43 793 A1, der DE 103 16 993 A1 und der US 5432 675 A weitere Befestigungsvorrichtungen bekannt.

Zudem sei noch die Parallelanmeldung EP 2 594 928 erwähnt.

Vor diesem Hintergrund besteht die Aufgabe der Erfindung darin, eine Vorrichtung anzugeben, der den Stand der Technik weiterbildet.

Die Aufgabe wird durch eine Vorrichtung mit den Merkmalen des Patentanspruchs 1 gelöst. Vorteilhafte Ausgestaltungen der Erfindung sind in den Unteransprüchen enthalten.

Gemäß dem Gegenstand der Erfindung wird ein integriertes Bauelement mit Leitkleberverbindung bereitgestellt, aufweisend einen Halbleiterkörper mit einer integrierten Schaltung, einer an der Oberfläche des Halbleiterkörpers ausgebildeten dielektrischen Passivierungsschicht, eine unterhalb der Passivierungsschicht ausgebildete

Leiterbahn und einer unterhalb der Leiterbahn ausgebildeten Oxidschicht, und einem Verbindungsmittel, das ein organisches Polymer umfasst, das eine kraftschlüssige Verbindung zwischen einem oberhalb der Passivierungsschicht ausgebildeten Bauteil und dem Halbleiterkörper ausbildet, wobei eine die Passivierungsschicht und die Oxidschicht durchdringende Ausformung mit einer Bodenfläche ausgebildet ist und an der Bodenfläche und / oder an einer Seitenfläche der Ausformung eine leitfähige Schicht ausgebildet ist und das Verbindungsmittel ein organisches Polymer umfasst und eine elektrische Verbindung zwischen der leitfähigen Schicht und dem Bauteil ausbildet. Es sei angemerkt, dass unter dem Begriff des Verbindungsmittels, derartige Verbindungsmittel verstanden werden, welche bei Raumtemperatur flüssig sind. Derartige Verbindungsmittel werden auch als Leitkleber bezeichnet.

Ein Vorteil ist, dass sich mittels eines elektrisch leitfähigen Verbindungsmittels weitere Teile von separaten Bauteilen mit dem Halbleiterkörper sowohl elektrisch als auch gleichzeitig kraftschlüssig verbinden lassen. Hierbei werden mit dem Ausdruck "separat" insbesondere solche Bauteile umfasst, welche nicht in dem Herstellungsprozess der integrierten Schaltung erzeugt werden. Untersuchungen haben gezeigt, dass mit der neuartigen Befestigung eine aufwändige mechanische Anbringung vorzugsweise mittels eines Hebel- oder Einrastmechanismus oder anderen Befestigungsmitteln und einer zusätzlich separaten elektrischen Verbindung beispielsweise mittels eines Bonddrahtes entfällt. Mit der neuen Technik lassen sich einfache, zuverlässige und kostengünstige Verbindungen zwischen einem Halbleiterkörper und separaten Bauteilen schaffen. Unter dem Begriff Bauteile werden insbesondere elektronische, elektromechanische Bauteile und Teile davon wie beispielsweise eine separate Steuerelektrode eines Gassensortransistors verstanden. Hierbei ist das Bauteil als ein erster Teil und das Verbindungsmittel als ein zweiter Teil eines unterhalb der Passivierungsschicht ausgebildeten integrierten Bauelements vorgesehen. Vorzugsweise besteht zwischen den unterschiedlichen Teilen eine Signalverbindung. Anders ausgedrückt stehen die einzelnen Teile des integrierten Bauelements in einer elektrischen Wirkverbindung und bilden erst gemeinsam das vollständige Bauelement aus. In einer bevorzugten Ausführungsform bildet die Passivierungsschicht ein Plateau aus. Das Bauteil liegt auf dem Plateau auf. In einer alternativen Ausführungsform bildet das Verbindungsmittel außerhalb der Ausformung auf der Passivierungsschicht einen großen Auflagebereich aus, wobei das erste Bauteil auf dem Auflagebereich aufliegt. Unter einem großen Auflagebereich wird eine Fläche verstanden, deren Maße wesentlich größer als die Fläche der Ausformung in der Ebene der Passivierungsschicht ist.

Ein weiterer Vorteil ist, dass die Herstellung der Ausformung bereits auf der sogenannten Waferlevelebene durchgeführt wird und hierdurch sich die Herstellung der Ausformung ohne Weiters in den Herstellungsprozess einer integrierten Schaltung einfügen lässt. Vorzugsweise wird zur Herstellung der Ausformung ein Trockenätzprozess, insbesondere der Padfensterätzprozess nach dem Aufbringung der Passivierung verwendet. Derartige Herstellungsschritte nach dem Aufbringen werden auch als Back End of Line Prozesse bezeichnet.

Weitere Untersuchungen haben gezeigt, dass je nach Verwendung bereits eine geringe elektrische Leitfähigkeit des Verbindungsmittels unterhalb 50 MOhm, höchst vorzugsweise unterhalb 1 MOhm ausreicht, um eine beispielsweise eine separate Steuerelektrode eines SGFETs oder CCFETs mit der Unterlage, d.h. dem Halbleiterköper zu verbinden. Hierdurch lässt sich die Herstellung der Gassensoren kostengünstiger und zuverlässiger ausführen. Des Weiteren verringert sich die Bauhöhe gegenüber einer Ausführung mit einem Bonddraht auf der Deckfläche der Steuerelektrode.

Gemäß einer bevorzugten Ausführungsform ist auf der Bodenfläche eine, vorzugsweise eine Vielzahl von Erhöhungen, die insbesondere kegelstumpfartig ausgeformt sind, ausgebildet. Bevorzugt ist, dass die Erhöhung von dem Verbindungsmittel vollständig umschlossen ist und insbesondere die Erhöhung mit dem Verbindungsmittel eine stoffschlüssige Verbindung ausbildet. Hierbei ist das Verbindungsmittel vorzugsweise als Leitkleber ausgebildet.

Gemäß einer Weiterbildung sind die Erhöhungen leitfähig ausgebildet, Insbesondere ist es bevorzugt, die Erhöhungen als Wolframplugs auszubilden. Ein Vorteil der Erhöhungen ist es, dass das Verbindungsmittel eine besonders zuverlässige mechanische und / oder elektrische Verbindung mit der Ausformung und insbesondere mit der Bodenfläche ausbildet. Anders ausgedrückt vergrößern die Wolframplugs bzw. die Erhöhungen die Oberfläche und hierdurch die mit dem Verbindungsmittel zu benetzende Oberfläche.

Gemäß einer anderen Ausführungsform enthält die leitfähige Schicht Silizium. Bevorzugt hierbei ist, dass die leitfähige Schicht eine dotierte Polysiliziumschicht und / oder einer Silizidschicht umfasst. In einer alternativen Ausführungsform wird die leitfähige Schicht von einer metallischen Leiterbahn oder einer Metallbahn gebildet.

In einer Weiterbildung füllt das Verbindungsmittel die Ausformung vollständig aus. Hierdurch lassen sich besonders zuverlässige Verbindungen zwischen dem Halbleiterkörper und dem Bauteil ausbilden. Ein Vorteil ist, dass das Verbindungsmittel die Ausformung gegen Verunreinigungen abdichtet, so dass keine Fremdstoffe eindringen.

Gemäß einer Weiterbildung ist es bevorzugt, die Ausformung grabenförmig oder lochförmig auszubilden. Gemäß einer alternativen Ausführungsform ist es bevorzugt, ein Teil einer Seitenfläche der Ausformung mit einer leitfähigen Schicht auszubilden. Untersuchungen haben gezeigt, dass sich innerhalb der Ausformung sowohl eine Leiterbahnschicht als auch eine siliziumhaltige Schicht, vorzugsweise eine dotierte Polysiliziumschicht mit einer aufliegenden Silizidschicht eignet. Hierbei ist es vorteilhaft, die Silizidschicht als Wolframsilizid auszubilden.

Die Erfindung wird nachfolgend unter Bezugnahme auf die Zeichnungen näher erläutert. Hierbei werden gleichartige Teile mit identischen Bezeichnungen beschriftet. Die dargestellte Ausführungsformen sind stark schematisiert, d.h. die Abstände und laterale und vertikale Erstreckung sind nicht maßstäblich und weisen, sofern nicht anders angegeben auch keine ableitbare geometrische Relation zueinander auf. Darin zeigen die:
- Figur 1: eine Querschnittsansicht auf eine erste Ausführungsform,
- Figur 2: eine Querschnittsansicht auf eine zweite Ausführungsform.

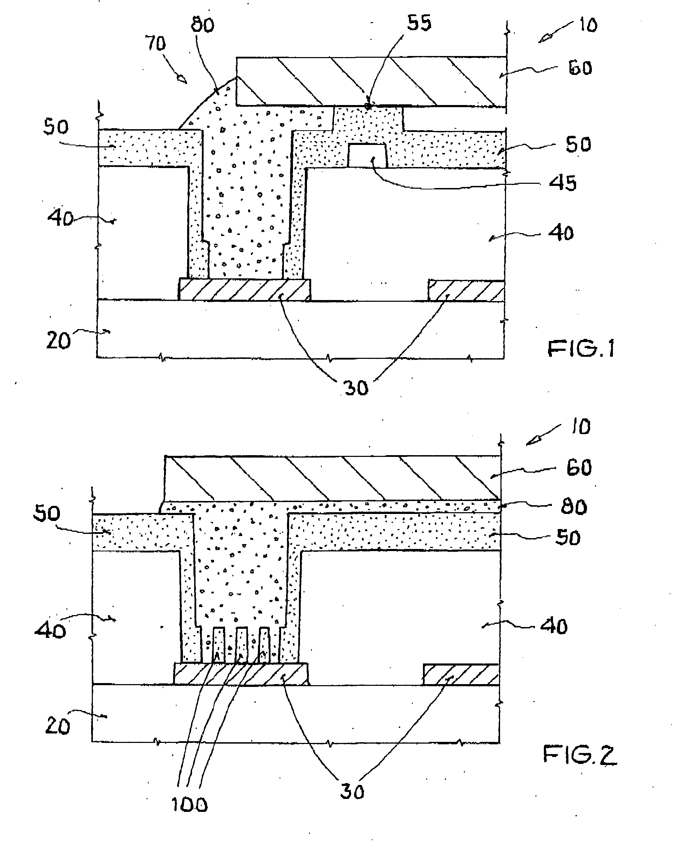

Die Abbildung der Figur 1 zeigt eine Querschnittsansicht auf eine erste Ausführungsform eines integriertes Bauelements mit Leitkleberverbindung 10, aufweisend einen Halbleiterkörper 20, eine integrierte Schaltung - nicht dargestellt- eine auf der Oberfläche des Halbleiterkörpers 20 ausgebildete leitfähige Polysiliziumschicht 30, eine Oxidschicht 40, eine auf der Oxidschicht 40 aufliegende Leiterbahn 45 und eine Passivierung 50. Es sei angemerkt, dass die Leiterbahn 45 Teil einer nicht weiter dargestellten obersten Leiterbahnebene, die auch die Metallflächen zur Aufnahme von Bonddrähten ausbildet, ist. Ferner besteht die Oxidschicht 40 vorzugsweise aus mehreren Oxidschichten, wobei die Oxidschichten im Allgemeinen im Rahmen der Ausbildung einer Mehrebenenmetalllsierung abgeschieden werden. Die Passivierung 50 besteht aus Siliziumnitrid und bildet oberhalb der Leiterbahn 45 ein Plateau 55 aus. Auf dem Plateau 55 aufliegend ist ein mit dem Halbleiterkörper 20 anzuschließendes Bauteil 60, das beispielsweise als Steuerelektrode eines Gassensors ausgebildet ist, angeordnet. Das formschlüssig aufliegende Bauteil 60 bildet mit dem Plateau 55 einen Falz aus. Um das Bauteil 60 zuverlässig kraftschlüssig und elektrisch mit dem Halbleiterkörper 20 zu verbinden, füllt das das Verbindungsmittel 80 die Ausformung 70 und den Falz vollständig aus. Des Weiteren wird von dem Verbindungsmittel 80 auch ein Teil der Seitenfläche des Bauteils 60 und ein Teil der Passivierung 50 auf der Oberfläche des Halbleiterkörpers 20 umfasst. Hierdurch bildet das Verbindungsmittel 80 sowohl einen elektrischen Kontakt als auch eine kraftschlüssige Verbindung zwischen dem Halbleiterkörper 20 und dem Bauteil 60 aus. Die Verbindung ist des Weiteren sehr zuverlässig und alterungsbeständig. Ein Vorteil der vollständigen Ausfüllung der Ausformung 70 ist die hierdurch erzeugte passivierende Ausführung, d.h. ein Eindringen von Fremdstoffen wird unterdrückt.

Das Bauteil 60 ist vorzugsweise wenigstens an der zu der Passivierung 50 hingewandten Seite elektrisch leitfähig ausgebildet. Eine Ausformung 70 ist vorzugsweise als graben- oder lochartige Struktur ausgebildet und durchgreift die Passivierung 50, wobei in dem Bodenbereich der Ausformung 70 die Polysiliziumschicht 30 und an den Wänden der Ausformung 70 die Passivierung 50 ausgebildet ist. Hierdurch wird ersichtlich, dass die Ausformung 70 mittels eines Ätzprozesses vor der Abscheidung der Passivierung 50 aufgebracht worden ist. Anschließend wird die Polysiliziumschicht 30 mit einem sogenannten Padfensterätzprozess in dem Bodenbereich der Ausformung 70 freigelegt. In einer nicht dargestellten alternativen Ausführungsform lässt sich die Ausformung 70 auch nach dem Abscheiden der Passivierung 50 herstellen. Hierbei ist an den Seitenflächen der Ausformung 70 keine Passivierungsschicht 50 ausgebildet.

Gemäß der Darstellung der Figur 1 ist die Ausformung 70 mittels des Verbindungsmittels 80 ausgefüllt. Das Verbindungsmittel 80 umgreift das Bauteil 60 teilweise an einer Seitenfläche und bildet eine stoffschlüssige Verbindung mit dem Bauteil 60 und mit der Oberfläche der Ausformung aus.

In der Abbildung der Figur 2 ist eine zweite Ausführungsform dargestellt. Im Folgenden werden nur die Unterschiede zu der Ausführungsform der Darstellung der Figur 1 erläutert. Das Bauteil 60 überdeckt die Ausformung 70 vollständig. Zwischen dem Bauteil 60 und der Passivierung 50 ist außerhalb der Ausformung 70 das Verbindungsmittel 80 ausgebildet, d.h. es bildet sich ein großer Auflagebereich für das Bauteil 70 aus. Auf der Bodenfläche der Ausformung 70 bzw. auf der Polysiliziumschicht 30 ist eine Vielzahl von kegelstumpfartigen Erhöhungen, die vorzugsweise als Wolframplugs 100 ausgebildet sind, angeordnet. Die Wolframplugs 100 bilden mit der Unterlage, die bevorzugt eine nicht dargestellte Silizidschicht, höchst vorzugsweise eine Wolframsilizidschicht aufweist, eine stoffschlüssige und kraftschlüssige Verbindung aus. Die Wolframplugs 100 sind jeweils mit dem Verbindungsmittel 80 umhüllt. Hierdurch wird eine besonders feste und zuverlässige Verbindung zwischen dem Verbindungsmittel 80 und dem Bodenbereich der Ausformung 70 erreicht.

## Patentansprüche

1. Integriertes Bauelement mit Leitkleberverbindung (10) aufweisend,
- einen Halbleiterkörper (20) mit einer integrierten Schaltung,
- einer an der Oberfläche des Halbleiterkörpers (20) ausgebildete dielektrische Passivierungsschicht (50),
- eine unterhalb der Passivierungsschicht (50) ausgebildete Leiterbahn (45),
- einer unterhalb der Leiterbahn (45) ausgebildete Oxidschicht (40),
- einem Verbindungsmittel (80), das eine kraftschlüssige Verbindung zwischen einem oberhalb der Passivierungsschicht (50) ausgebildeten Bauteil (60) und dem Halbleiterkörper (20) ausbildet,
- eine die Passivierungsschicht (50) und die Oxidschicht (40) durchdringende Ausformung (70) mit einer Bodenfläche und an der Bodenfläche und / oder an einer Seitenfläche der Ausformung eine leitfähige Schicht ausgebildet ist und das Verbindungsmittel (80) ein organisches Polymer umfasst und eine elektrische Verbindung zwischen der leitfähigen Schicht und dem Bauteil (60) ausbildet,
**dadurch gekennzeichnet, dass**
das Bauteil (60) als ein erster Teil und das Verbindungsmittel (80) als ein zweiter mit einem unterhalb der Passivierungsschicht (50) angeordneten weiteren Teil ein integrierten Bauelements bilden und die Passivierungsschicht (50) aus Siliziumnitrid besteht

2. Integriertes Bauelement mit Leitkleberverbindung (10) nach Anspruch 1, **dadurch gekennzeichnet, dass** auf der Bodenfläche eine Erhöhung oder eine Vielzahl von Erhöhungen ausgebildet sind.

3. Integriertes Bauelement mit Leitkleberverbindung (10) nach Anspruch 2, **dadurch gekennzeichnet, dass** die Erhöhung als Wolframplug (100) ausgebildet ist.

4. Integriertes Bauelement mit Leitkleberverbindung (10) nach einem der Ansprüche 2 bis 3, **dadurch gekennzeichnet, dass** die Erhöhung von dem Verbindungsmittel (80) vollständig umschlossen ist.

5. Integriertes Bauelement mit Leitkleberverbindung (10) nach einem der Ansprüche 2 bis 4, **dadurch gekennzeichnet, dass** die Erhöhung mit dem Verbindungsmittel (80) eine stoffschlüssige Verbindung ausbildet.

6. Integriertes Bauelement mit Leitkleberverbindung (10) nach einem der vorstehenden Ansprüche, **dadurch gekennzeichnet, dass** die leitfähige Schicht Silizium enthält.

7. Integriertes Bauelement mit Leitkleberverbindung (10) nach einem der vorstehenden Ansprüche, **dadurch gekennzeichnet, dass** die leitfähige Schicht aus einer dotierten Polysiliziumschicht (30) und einer Silizidschicht ausgebildet ist.

8. Integriertes Bauelement mit Leitkleberverbindung (10) nach einem der vorstehenden Ansprüche, **dadurch gekennzeichnet, dass** die leitfähige Schicht von einer Metallbahn gebildet wird.

9. Integriertes Bauelement mit Leitkleberverbindung (10) nach einem der vorstehenden Ansprüche, **dadurch gekennzeichnet, dass** das Verbindungsmittel (80) die Ausformung (70) vollständig ausfüllt.

10. Integriertes Bauelement mit Leitkleberverbindung (10) nach einem der vorangehenden Ansprüche, **dadurch gekennzeichnet, dass** das Verbindungsmittel (80) ein Leitkleber enthält.

11. Integriertes Bauelement mit Leitkleberverbindung (10) nach einem der vorangehenden Ansprüche, **dadurch gekennzeichnet, dass** das Bauteil (60) als Steuerelektrode eines Gassensortransistors ausgebildet ist.

12. Integriertes Bauelement mit Leitkleberverbindung (10) nach einem der vorangehenden Ansprüche, **dadurch gekennzeichnet, dass** die Passivierungsschicht (50) ein Plateau (55) ausbildet und das Bauteil (60) auf dem Plateau (55) aufliegt oder das Verbindungsmittel (80) außerhalb der Ausformung (70) auf der Passivierungsschicht (50) einen großen Auflagebereich ausbildet und das Bauteil (60) auf dem Auflagebereich aufliegt.

13. Integriertes Bauelement mit Leitkleberverbindung (10) nach einem der vorangehenden Ansprüche, **dadurch gekennzeichnet, dass** das Bauteil (60) die Ausformung (70) vollständig überdeckt.

14. Integriertes Bauelement mit Leitkleberverbindung (10) nach einem der vorangehenden Ansprüche, **dadurch gekennzeichnet, dass** an den Wänden der Ausformung (70) die Passivierung (50) ausgebildet ist.

15. Integriertes Bauelement mit Leitkleberverbindung (10) nach einem der Ansprüche 1 bis 13, **dadurch gekennzeichnet, dass** an den Seitenflächen der Ausformung (70) keine Passivierungsschicht (50) ausgebildet ist.

## Claims

1. Integrated component with conductive adhesive connection (10), comprising
- a semiconductor body (20) with an integrated circuit,
- a dielectric passivating layer (50) formed at the surface of the semiconductor body (20),
- a conductor track (45) formed below the passivating layer (50),
- an oxide layer (40) formed below the conductor track (45),
- a connecting means (80) forming a force-locking connection between a component (60), which is formed above the passivating layer (50), and the semiconductor body (20),
- a shaped-out-out portion (70), which penetrates the passivating layer (50) and the oxide layer (40), with a base surface, and a conductive layer is formed at the base surface and/or at a side surface ofi the shaped-out portion and the connecting means (80) comprises an organic polymer and forms an electrical connection between the conductive layer and the component (60),
**characterised in that**
the component (60) as a first part and the connecting means (80) as a second part form together with a further part arranged below the passivating layer (50) an integrated component and the passivating layer (50) consists of silicon nitride.

2. Integrated component with conductive adhesive connection (10) according to claim 1, **characterised in that** an elevation or a plurality of elevations is formed on the base surface.

3. Integrated component with conductive adhesive connection (10) according to claim 2, **characterised in that** the elevation is constructed as a tungsten plug (100)

4. Integrated component with conductive adhesive connection (10) according to one of claims 2 and 3, **characterised in that** the elevation is completely enclosed by the connecting means (80).

5. Integrated component with conductive adhesive connection (10) according to any one of claims 2 to 4, **characterised in that** the elevation forms a material-bonding connection with the connecting means (80).

6. Integrated component with conductive adhesive connection (10) according to any one of the preceding claims, **characterised in that** the conductive layer includes silicon.

7. Integrated component with conductive adhesive connection (10) according to any one of the preceding claims, **characterised in that** the conductive layer is formed from a doped polysilicon layer (20) and a silicide layer.

8. Integrated component with conductive adhesive connection (10) according to any one of the preceding claims, **characterised in that** the conductive layer is formed by a metal track.

9. Integrated component with conductive adhesive connection (10) according to any one of the preceding claims, **characterised in that** the connecting means (80) completely fills out the shaped-out portion (70).

10. Integrated component with conductive adhesive connection (10) according to any one of the preceding claims, **characterised in that** the connecting means (80) includes a conductive adhesive.

11. Integrated component with conductive adhesive connection (10) according to any one of the preceding claims, **characterised in that** the component (60) is constructed as a control electrode of a gas sensor transistor.

12. Integrated component with conductive adhesive connection (10) according to any one of the preceding claims, **characterised in that** the passivating layer (50) forms a plateau (55) and the component (60) rests on the plateau (55) or the connecting means (60) forms a large support region outside the shaped-out portion (70) of the passivating layer (50) and the component (60) rests on the support region.

13. Integrated component with conductive adhesive connection (10) according to any one of the preceding claims, **characterised in that** the component (60) completely covers the shaped-oult portion (70).

14. Integrated component with conductive adhesive connection (10) according to any one of the preceding claims, **characterised in that** the passivating layer (50) is formed at the walls of the shaped-out portion (70).

15. Integrated component with conductive adhesive connection (10) according to any one of claims 1 to 13, **characterised in that** no passivating layer (50) is formed at the side surfaces of the shaped-out portion (70).

## Revendications

1. Composant intégré avec liaison adhésive conductrice (10) présentant
- un corps semi-conducteur (20) avec un circuit intégré,
- une couche de passivation diélectrique (50) formée sur la surface du corps semi-conducteur (20),
- une piste conductrice (45) formée en dessous de la couche de passivation (50),
- une couche d'oxyde (40) formée en dessous de la piste conductrice (45),
- un moyen de liaison (80), qui réalise une liaison par adhérence entre un élément (60) formé au-dessus de la couche de passivation (50) et le corps semi-conducteur (20),
- une forme (70) traversant la couche de passivation (50) et la couche d'oxyde (40), avec une face de fond et une couche conductrice est formée sur la face de fond et/ou sur une face latérale de la forme et le moyen de liaison (80) comprend un polymère organique et forme une liaison électrique entre la couche conductrice et l'élément (60),
**caractérisé en ce que** l'élément (60) comme première partie et le moyen de liaison (80) comme deuxième partie avec une autre partie disposée en dessous de la couche de passivation (50) forment un composant intégré et la couche de passivation (50) se compose de nitrure de silicium.

2. Composant intégré avec liaison adhésive conductrice (10) selon la revendication 1, **caractérisé en ce qu'**une surélévation ou une multiplicité de surélévations est/sont formée(s) sur la face de fond.

3. Composant intégré avec liaison adhésive conductrice (10) selon la revendication 2, **caractérisé en ce que** la surélévation est formée par un plot de tungstène (100).

4. Composant intégré avec liaison adhésive conductrice (10) selon l'une des revendications 2 à 3, **caractérisé en ce que** la surélévation est entourée entièrement par le moyen de liaison (80).

5. Composant intégré avec liaison adhésive conductrice (10) selon l'une quelconque des revendications 2 à 4, **caractérisé en ce que** la surélévation forme avec le moyen de liaison (80) une liaison matérielle.

6. Composant intégré avec liaison adhésive conductrice (10) selon l'une quelconque des revendications précédentes, **caractérisé en ce que** la couche conductrice contient du silicium.

7. Composant intégré avec liaison adhésive conductrice (10) selon l'une quelconque des revendications précédentes, **caractérisé en ce que** la couche conductrice est formée d'une couche de polysilicium dopée (30) et d'une couche de siliciure.

8. Composant intégré avec liaison adhésive conductrice (10) selon l'une quelconque des revendications précédentes, **caractérisé en ce que** la couche conductrice est formée par une bande de métal.

9. Composant intégré avec liaison adhésive conductrice (10) selon l'une quelconque des revendications précédentes, **caractérisé en ce que** le moyen de liaison (80) remplit entièrement la forme (70).

10. Composant intégré avec liaison adhésive conductrice (10) selon l'une quelconque des revendications précédentes, **caractérisé en ce que** le moyen de liaison (80) contient une colle conductrice.

11. Composant intégré avec liaison adhésive conductrice (10) selon l'une quelconque des revendications précédentes, **caractérisé en ce que** l'élément (60) est réalisé comme électrode de commande d'un transistor de capteur de gaz.

12. Composant intégré avec liaison adhésive conductrice (10) selon l'une quelconque des revendications précédentes, **caractérisé en ce que** la couche de passivation (50) forme un plateau (55) et l'élément (60) repose sur le plateau (55) ou le moyen de liaison (80) forme à l'extérieur de la forme (70) sur la couche de passivation (50) une grande zone de pose, et l'élément (60) repose sur la zone de pose.

13. Composant intégré avec liaison adhésive conductrice (10) selon l'une quelconque des revendications précédentes, **caractérisé en ce que** l'élément (60) recouvre entièrement la forme (70).

14. Composant intégré avec liaison adhésive conductrice (10) selon l'une quelconque des revendications précédentes, **caractérisé en ce que** la passivation (50) est formée sur les parois de la forme (70).

15. Composant intégré avec liaison adhésive conductrice (10) selon l'une quelconque des revendications 1 à 13, **caractérisé en ce qu'**aucune couche de passivation (50) n'est formée sur les faces latérales de la forme (70).
